# EUROPEAN PATENT APPLICATION

(11) **EP 4 718 954 A1**
(43) Date of publication of application: **01.04.2026**
(21) Application number: 25193894.0
(22) Date of filing: 04.08.2025
(51) Int. Cl.: H05K 3/28, H01M 10/42

(54) **PROTECTION CIRCUIT MODULE, METHOD OF MANUFACTURING SAME AND SECONDARY BATTERY INCLUDING SAME**

(30) Priority: 26.09.2024 KR 20240130668
(71) Applicant: SAMSUNG SDI CO., LTD., Yongin-si, Gyeonggi-do 17084 (KR)
(72) Inventor: KANG, Myeonggyu, 17084 Yongin-Si (KR)
(74) Representative: Marks & Clerk LLP

(57) **Abstract**

A protection circuit module includes a substrate electrically connected to a battery cell, components in implementation regions on the substrate, a first insulating layer in regions other than the implementation regions on the substrate, a second insulating layer on the first insulating layer and separated from the components, and a coating layer on the first insulating layer and surrounding the components.

## Description

### BACKGROUND

### 1. Field

The present disclosure relates to a protection circuit module, a method of manufacturing a protection circuit module, and a secondary battery including a protection circuit module.

### 2. Description of the Related Art

Unlike primary batteries that are not designed to be (re)charged, secondary (or rechargeable) batteries are batteries that are designed to be discharged and recharged. Low-capacity secondary batteries are used in portable, small electronic devices, such as smart phones, feature phones, notebook computers, digital cameras, and camcorders, while large-capacity secondary batteries are widely used as power sources for driving motors in hybrid vehicles and electric vehicles and for storing power (e.g., home and/or utility scale power storage). A secondary battery generally includes an electrode assembly composed of a positive electrode and a negative electrode, a case accommodating the same, and electrode terminals connected to the electrode assembly.

In general, a protection circuit module (PCM) is provided in a secondary battery in order to protect the battery from overcharge, over-discharge, or over-current. Accordingly, the secondary battery is used in the form of a battery pack in which the protection circuit module is coupled with a battery cell.

Several components are provided on the substrate of the protection circuit module. A coating solution is applied to insulate the components on the protection circuit module and to protect the components from external impacts or the like. However, in a process of applying the coating solution, there is a problem that the coating solution may flow to adjacent configurations other than a region requiring the coating.

As electronic devices become smaller, it is desirable to make the substrate of the protection circuit module thin to make the battery pack smaller. However, when the substrate of the protection circuit module is made thin, there is a problem that the substrate is easily damaged by external impacts or the like.

The above information disclosed in this Background section is for enhancement of understanding of the background of the present disclosure, and therefore, it may contain information that does not constitute related (or prior) art.

### SUMMARY

The present disclosure relates to various embodiments of a protection circuit module and a method of manufacturing a protection circuit module for solving the above problems.

However, the technical problem to be solved by the present disclosure is not limited to the above problem, and other problems not mentioned herein, and aspects and features of the present disclosure that would address such problems, will be clearly understood by those skilled in the art from the description of the present disclosure below.

According to an embodiment of the present disclosure to solve the above technical problem, a protection circuit module includes a substrate electrically connected to a battery cell, a plurality of components on (or implemented in) implementation regions on (or of) the substrate, a first insulating layer (formed) in regions (of the substrate) other than the implementation regions on the substrate, a second insulating layer (formed) on the first insulating layer and (the second insulating layer being) separated from the plurality of components, and a coating layer (formed) on the first insulating layer and surrounding (or formed to surround) the plurality of components.

According to one or more embodiments, the second insulating layer may extend (or be formed) along an edge of the first insulating layer.

According to one or more embodiments, the first insulating layer may be in (or formed over) all (of) the regions other than the implementation regions on the substrate, and the second insulating layer may be (formed) at a position corresponding to the edge of the substrate.

According to one or more embodiments, the second insulating layer may have a closed contour, and the plurality of components may be (positioned) within the closed contour.

According to one or more embodiments, the coating layer may be within the closed contour and in the regions other than the implementation regions of the substrate. The coating layer may be positioned in the regions other than the implementation regions within the closed contour.

According to one or more embodiments, the second insulating layer may be (formed to be) thicker than the first insulating layer.

According to one or more embodiments, a height of the second insulating layer may be lower than a highest height among (a plurality of) heights of the plurality of components.

According to one or more embodiments, a height of the second insulating layer may be lower than a lowest height among (a plurality of) heights of the plurality of components.

According to one or more embodiments, the coating layer may be (formed to be) lower than the second insulating layer.

According to one or more embodiments, the coating layer may be (formed to be) lower than (each of) the plurality of components.

According to one or more embodiments, the first insulating layer and the second insulating layer may (each) include photo solder resist (PSR) ink.

According to one or more embodiments, the coating layer may include an underfill coating material.

According to some embodiments of the present disclosure, a method of manufacturing a protection circuit module includes forming a first insulating layer in regions (of the substrate) other than implementation regions (on the substrate, the implementation regions being regions) in which components are located on (or implemented on) a substrate, forming a second insulating layer on the first insulating layer and (the second insulating layer extending) along an edge of the first insulating layer (on the first insulating layer), forming (or implementing) a plurality of the components in the implementation regions, and forming a coating layer on the first insulating layer and surrounding (or to surround) the plurality of components.

According to one or more embodiments, the forming of the first insulating layer may include forming the first insulating layer in all (of) the regions other than the implementation regions on the substrate, and the forming of the second insulating layer may include forming the second insulating layer at a position corresponding to an edge of the substrate.

According to one or more embodiments, the forming of the second insulating layer may include forming the second insulating layer to have a closed contour, and the forming of the coating layer may include forming the coating layer to be positioned (within the closed contour and) in the regions other than the implementation regions (within the closed contour).

According to one or more embodiments, the forming of the second insulating layer may include forming the second insulating layer to be thicker than a thickness of the first insulating layer.

According to one or more embodiments, the forming of the second insulating layer may include forming the second insulating layer to be lower than a lowest height among (a plurality of heights) of the plurality of components (to be implemented).

According to one or more embodiments, the forming of the coating layer may include forming the coating layer to be lower than the second insulating layer.

According to some embodiments of the present disclosure, a secondary battery includes an electrode assembly, a case accommodating the electrode assembly, and a protection circuit module connected to the electrode assembly. The protection circuit module includes a substrate electrically connected to the electrode assembly, a plurality of components (implemented) in implementation regions on the substrate, a first insulating layer (formed) in regions other than the implementation regions on the substrate, a second insulating layer (formed) on the first insulating layer and (formed to be) separated from the plurality of components, and a coating layer (formed) on the first insulating layer and surrounding (or formed to surround) the plurality of components.

According to one or more embodiments, the second insulating layer may extend (or be formed) along an edge of the first insulating layer.

At least some of the above and other features of the invention are set out in the claims.

Optional features discussed above in relation to one embodiment may, where appropriate, be applied to another embodiment.

According to some embodiments of the present disclosure, the insulating layer may extend along the edge of the substrate and be higher than the height at which the coating layer is coated, and thus the coating layer can be prevented (or at least mitigated) from leaking out of the substrate of the protective circuit module.

According to some embodiments of the present disclosure, the implementation strength can be increased by forming a single coating layer surrounding all of the plurality of components on the substrate of the protection circuit module.

However, aspects and features of the present disclosure are not limited to those described above, and other aspects and features not mentioned will be clearly understood by a person skilled in the art from the detailed description, described below.

### BRIEF DESCRIPTION OF THE DRAWINGS

The following drawings attached to this specification illustrate embodiments of the present disclosure, and further describe aspects and features of the present disclosure together with the detailed description of the present disclosure. Thus, the present disclosure should not be construed as being limited to the drawings.
Fig. 1 is an exploded perspective view of an electrode assembly and a case according to one embodiment of the present disclosure.
Fig. 2 is a diagram illustrating a battery cell according to one embodiment of the present disclosure.
Fig. 3 is a diagram illustrating a battery cell and a protection circuit module according to one embodiment of the present disclosure.
Fig. 4 is a diagram illustrating an upper surface of the protection circuit module according to one embodiment of the present disclosure.
Fig. 5 is a diagram illustrating a section taken along line A-A' of Fig. 4.
Fig. 6 is a diagram illustrating another embodiment of the protection circuit.
Figs. 7 to 15 are diagrams depicting tasks of a manufacturing process of the protection circuit module according to one embodiment of the present disclosure.
Fig. 16 is a flowchart illustrating tasks of the manufacturing process of the protection circuit module according to one embodiment of the present disclosure.

### DETAILED DESCRIPTION

Hereinafter, embodiments of the present disclosure will be described, in detail, with reference to the accompanying drawings. The terms or words used in the present specification and claims are not to be limitedly interpreted as general or dictionary meanings and should be interpreted as meanings and concepts that are consistent with the technical idea of the present disclosure on the basis of the principle that an inventor can be his/her own lexicographer to appropriately define concepts of terms to describe his/her invention in the best way.

The embodiments described in this specification and the configurations shown in the drawings are only some of the embodiments of the present disclosure and do not represent all of the technical aspects, and features of the present disclosure. Accordingly, it should be understood that there may be various equivalents and modifications that can replace or modify the embodiments described herein at the time of filing this application.

It will be understood that when an element or layer is referred to as being "on," "connected to," or "coupled to" another element or layer, it may be directly on, connected, or coupled to the other element or layer or one or more intervening elements or layers may also be present. When an element or layer is referred to as being "directly on," "directly connected to," or "directly coupled to" another element or layer, there are no intervening elements or layers present. For example, when a first element is described as being "coupled" or "connected" to a second element, the first element may be directly coupled or connected to the second element or the first element may be indirectly coupled or connected to the second element via one or more intervening elements.

In the figures, dimensions of the various elements, layers, etc. may be exaggerated for clarity of illustration. The same reference numerals designate the same elements. As used herein, the term "and/or" includes any and all combinations of one or more of the associated listed items. Further, the use of "may" when describing embodiments of the present disclosure relates to "one or more embodiments of the present disclosure." Expressions, such as "at least one of" and "any one of," when preceding a list of elements, modify the entire list of elements and do not modify the individual elements of the list. When phrases such as "at least one of A, B and C, "at least one of A, B or C," "at least one selected from a group of A, B and C," or "at least one selected from among A, B and C" are used to designate a list of elements A, B and C, the phrase may refer to any and all suitable combinations or a subset of A, B and C, such as A, B, C, A and B, A and C, B and C, or A and B and C. As used herein, the terms "use," "using," and "used" may be considered synonymous with the terms "utilize," "utilizing," and "utilized," respectively. As used herein, the terms "substantially," "about," and similar terms are used as terms of approximation and not as terms of degree, and are intended to account for the inherent variations in measured or calculated values that would be recognized by those of ordinary skill in the art.

It will be understood that, although the terms first, second, third, etc. may be used herein to describe various elements, components, regions, layers, and/or sections, these elements, components, regions, layers, and/or sections should not be limited by these terms. These terms are used to distinguish one element, component, region, layer, or section from another element, component, region, layer, or section. Thus, a first element, component, region, layer, or section discussed below could be termed a second element, component, region, layer, or section without departing from the teachings of example embodiments.

Spatially relative terms, such as "beneath," "below," "lower," "above," "upper," and the like, may be used herein for ease of description to describe one element or feature's relationship to another element(s) or feature(s) as illustrated in the figures. It will be understood that the spatially relative terms are intended to encompass different orientations of the device in use or operation in addition to the orientation depicted in the figures. For example, if the device in the figures is turned over, elements described as "below" or "beneath" other elements or features would then be oriented "above" or "over" the other elements or features. Thus, the term "below" may encompass both an orientation of above and below. The device may be otherwise oriented (rotated 90 degrees or at other orientations), and the spatially relative descriptors used herein should be interpreted accordingly.

The terminology used herein is for the purpose of describing embodiments of the present disclosure and is not intended to be limiting of the present disclosure. As used herein, the singular forms "a" and "an" are intended to include the plural forms as well, unless the context clearly indicates otherwise. It will be further understood that the terms "includes," "including," "comprises," and/or "comprising," when used in this specification, specify the presence of stated features, integers, steps, operations, elements, and/or components but do not preclude the presence or addition of one or more other features, integers, steps, operations, elements, components, and/or groups thereof.

Also, any numerical range disclosed and/or recited herein is intended to include all sub-ranges of the same numerical precision subsumed within the recited range. For example, a range of "1.0 to 10.0" is intended to include all subranges between (and including) the recited minimum value of 1.0 and the recited maximum value of 10.0, that is, having a minimum value equal to or greater than 1.0 and a maximum value equal to or less than 10.0, such as, for example, 2.4 to 7.6. Any maximum numerical limitation recited herein is intended to include all lower numerical limitations subsumed therein, and any minimum numerical limitation recited in this specification is intended to include all higher numerical limitations subsumed therein.

References to two compared elements, features, etc. as being "the same" may mean that they are "substantially the same". Thus, the phrase "substantially the same" may include a case having a deviation that is considered low in the art, for example, a deviation of 5% or less. In addition, when a certain parameter is referred to as being uniform in a given region, it may mean that it is uniform in terms of an average.

Throughout the specification, unless otherwise stated, each element may be singular or plural.

Arranging an arbitrary element "above (or below)" or "on (under)" another element may mean that the arbitrary element may be disposed in contact with the upper (or lower) surface of the element, and another element may also be interposed between the element and the arbitrary element disposed on (or under) the element.

In addition, it will be understood that when a component is referred to as being "linked," "coupled," or "connected" to another component, the elements may be directly "coupled," "linked" or "connected" to each other, or another component may be "interposed" between the components".

Throughout the specification, when "A and/or B" is stated, it means A, B or A and B, unless otherwise stated. That is, "and/or" includes any or all combinations of a plurality of items enumerated. When "C to D" is stated, it means C or more and D or less, unless otherwise specified.

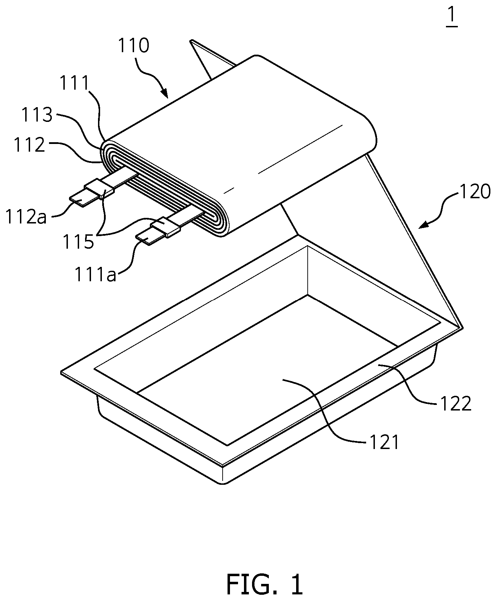

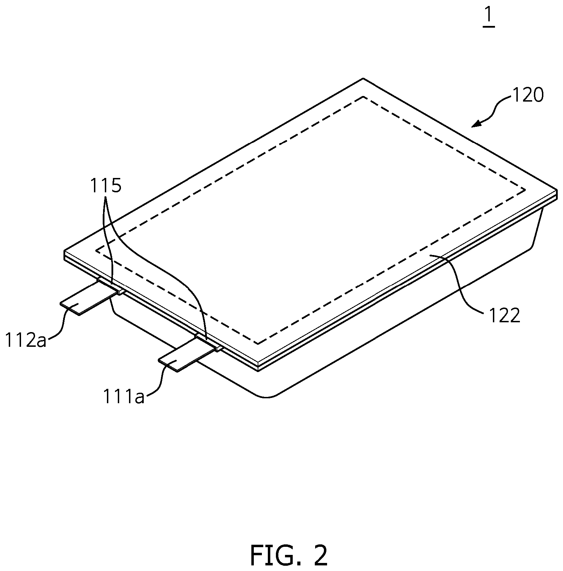

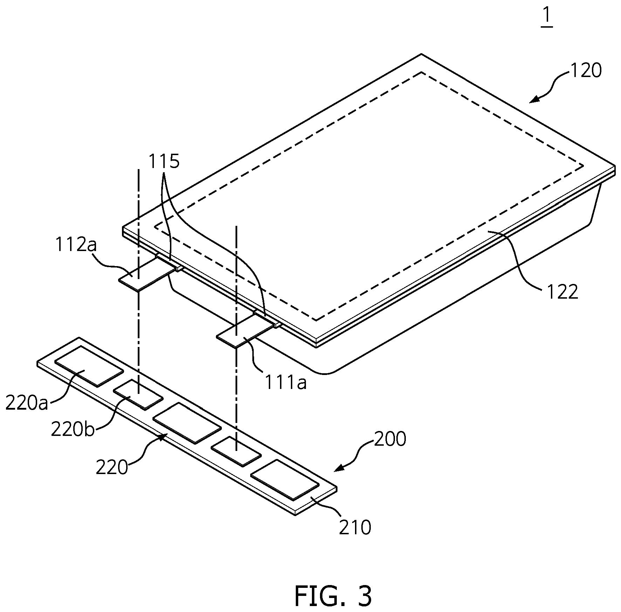

Fig. 1 is a diagram illustrating a configuration in which an electrode assembly and a case are coupled according to one embodiment of the present disclosure. Fig. 2 is a diagram illustrating a battery cell according to one embodiment of the present disclosure. Fig. 3 is a diagram illustrating a battery cell and a protection circuit module according to one embodiment of the present disclosure.

A secondary battery 1 according to one embodiment of the present disclosure is not limited to a pouch-type battery illustrated in Figs. 1 to 3. However, for the sake of convenience in description, the following description focuses on pouch-type batteries.

Referring to Figs. 1 to 3, the secondary battery 1 according to one embodiment of the present disclosure may include an electrode assembly 110, a case 120, and a protection circuit module 200.

According to one embodiment, the electrode assembly 110 may include a first electrode plate 111, a second electrode plate 112, and a separator 113 between the first electrode plate 11 and the second electrode plate 112. The first electrode plate 111 may be a negative electrode plate, and the second electrode plate 112 may be a positive electrode plate. In other embodiments, the first electrode plate 111 may be a positive electrode plate and the second electrode plate 112 may be a negative electrode plate.

According to one embodiment, the electrode assembly 110 may be formed by winding or stacking the first electrode plate 111, the separator 113, and the second electrode plate 112, each of which is formed in a thin plate shape or a film shape. When the electrode assembly 110 is a wound stacked body, a winding axis may be parallel (or substantially parallel) to a major axis direction of the case 120. The electrode assembly 110 may be the stacked type rather than the wound type, and a shape of the electrode assembly 110 is not limited in the present disclosure.

According to one embodiment, the first electrode plate 111 may be formed by applying an active material such as graphite or carbon to a current collector plate made of a metal foil such as copper, a copper alloy, nickel, or a nickel alloy. The first electrode plate 111 may include a first non-coated portion, which is a region where an active material is not applied. The first non-coated portion may be connected to a separately formed first electrode tab 111a, or a part of the first non-coated portion may be punched out to form the first electrode tab 111a.

According to one embodiment, the second electrode plate 112 may be formed by applying an active material such as a transition metal oxide to a current collector plate made of a metal foil such as aluminum or an aluminum alloy. The second electrode plate 112 may include a second non-coated portion, which is a region where an active material is not applied. The second non-coated portion may be connected to a separately formed second electrode tab 112a, or a part of the second non-coated portion may be punched out to form the second electrode tab 112a.

According to one embodiment, the separator 113 may be positioned between the first electrode plate 111 and the second electrode plate 112. The separator 113 may insulate the first electrode plate 111 and the second electrode plate 112, and may allow lithium ions to be exchanged between the first electrode plate 111 and the second electrode plate 112. Even though the electrode assembly 110 shrinks or expands during a process of charging and discharging the secondary battery 1, the separator 113 may have a sufficient length to completely (or substantially completely) insulate the first electrode plate 111 and the second electrode plate 112.

According to one embodiment, the first electrode tab 111a and the second electrode tab 112a may be provided on one side of the electrode assembly 110. The first electrode tab 111a and the second electrode tab 112a may correspond to the first electrode plate 111 and the second electrode plate 112, respectively, and may protrude from one side of each of the first electrode plate 111 and the second electrode plate 112, respectively. The first electrode tab 111a may be electrically connected to a first electrode, and the second electrode tab 112a may be electrically connected to a second electrode.

According to one embodiment, film portions 115 may be provided on the first electrode tab 111a and the second electrode tab 112a, respectively. The film portions 115 may be provided on one surface of each of the first electrode tab 111a and the second electrode tab 112a or may wrap around both surfaces of the first electrode tab 111a and the second electrode tab 112a. The film portions 115 are configured to prevent (or at least mitigate) a short circuit from occurring when the first electrode tab 111a and the second electrode tab 112a come into contact with a metal layer exposed at a section of a sealing portion 122 of the case 120. The film portions 115 may be thermally fused with the sealing portion 122 to tightly couple the first electrode tab 111a and the second electrode tab 112a with the sealing portion 122.

According to one embodiment, the case 120 may form an exterior of the secondary battery 1. The case 120 may have, but is not limited to, a rectangular parallelepiped shape as illustrated in Figs. 1 to 3.

According to one embodiment, the case 120 may include a receptacle 121 and the sealing portion 122.

According to one embodiment, the receptacle 121 may have an internal space having dimensions larger than dimensions of the electrode assembly 110 and may receive (accommodate) the electrode assembly 110 and an electrolyte. In a state in which the electrode assembly 110 is accommodated in the receptacle 121, a cover of the case 120 may be covered to seal the electrode assembly 110.

According to one embodiment, the sealing portion 122 may be along an edge of the case 120. The sealing portion 122 on the edge of the case 120 may come into contact with another portion of the case 120 and may be sealed in a state in which the electrode assembly 110 is accommodated in the case 120. In one embodiment, parts of the first electrode tab 111a and the second electrode tab 112a may be exposed to an outside of the case 120, and the film portions 115 may be positioned between an upper portion and a lower portion of the case 120 corresponding to the sealing portion 122.

According to one embodiment, the sealing portion 122 may be made of a thermal fusion material and may have a structure in which sealing is achieved by bonding thermal fusion layers to each other. For example, because the thermal fusion material generally has weak adhesion to metal, the film portions 115 may be attached to the first electrode tab 111a and the second electrode tab 112a in a form of a thin film and may be fused to the case 120 along the sealing portion 122.

According to one embodiment, the protection circuit module 200 may be configured to protect the battery cell of the secondary battery 1 from overcharge, overdischarge, and overcurrent.

According to one embodiment, the protection circuit module 200 may be electrically connected to the electrode assembly 110. The protection circuit module 200 may be electrically connected to the electrode assembly 110 accommodated in the case 120. As illustrated in Fig. 3, the protection circuit module 200 may be connected to the first electrode tab 111a and the second electrode tab 112a exposed to the outside of the case 120.

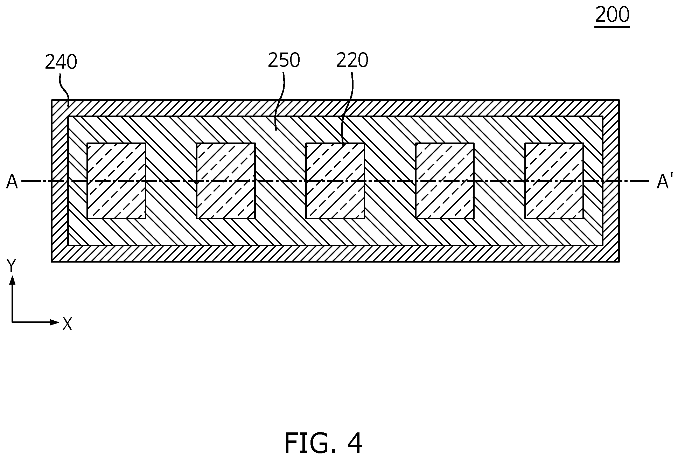

A configuration of the protection circuit module 200 according to one embodiment of the present disclosure will be described below with reference to Figs. 4 to 6.

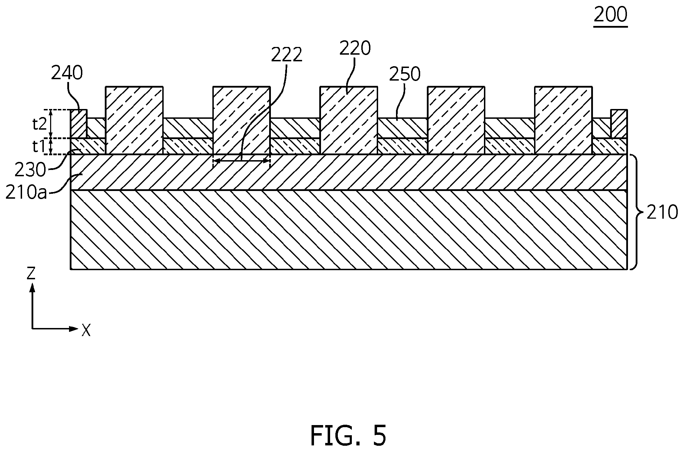

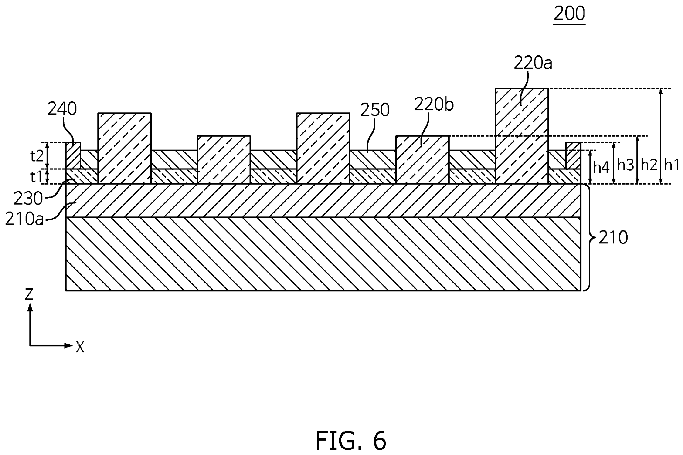

Fig. 4 is a diagram illustrating an upper surface of the protection circuit module 200 according to one embodiment of the present disclosure. Fig. 5 is a diagram illustrating a section taken along line A-A' of Fig. 4. Fig. 6 is a diagram illustrating another embodiment of the protection circuit module 200.

Referring to Figs. 4 to 6, the protection circuit module 200 may include a substrate 210, a plurality of components 220 on the substrate 210, a first insulating layer 230, a second insulating layer 240, and a coating layer 250.

In one embodiment, the substrate 210 may be electrically connected to the battery cell. The substrate 210 may support a configuration of the protection circuit module 200. Various electric circuits and components configured to control an operation of the electrode assembly 110 may be on the substrate 210. The components on the substrate 210 may be configured to communicate with external control devices in a wired or wireless manner. The substrate 210 may be a printed circuit board (PCB) substrate 210. The substrate 210 may be made of one or more of FR-1, FR-4, CEM-1, CEM-3, TEFLON, ceramic, and/or metal. The substrate 210 may be a flexible circuit board. The substrate 210 may include a metal layer 210a configured to allow electrical signals to flow between the components. For example, the metal layer 210a may be a copper layer containing copper, but is not limited thereto. The metal layer 210a is illustrated as being formed over the entire substrate, but the present disclosure is not limited thereto. The metal layer 210a may be a configuration for electrical connection for component operation and may be formed only in a partial region of the substrate.

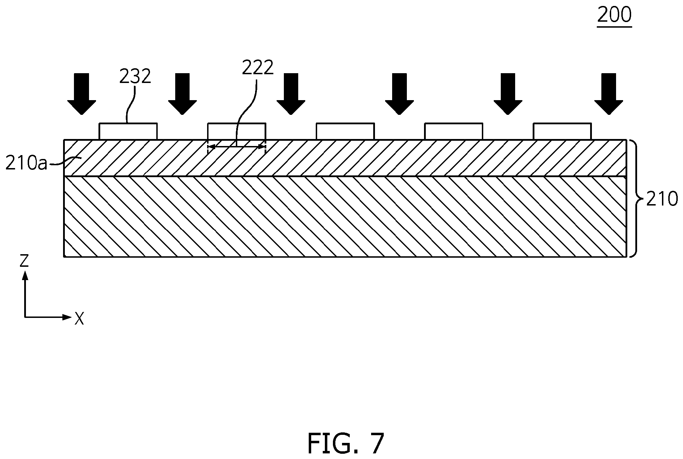

According to one embodiment, the plurality of components 220 may be in implementation regions 222 (see Fig. 7) on the substrate 210. Each of the plurality of components 220 may be configured to transmit and/or receive an electrical signal through the metal layer 210a. The plurality of components 220 may be in the implementation regions 222 on the substrate 210 in regions in which the first insulating layer 230 is not formed. The plurality of components 220 may be in the implementation regions 222 and may be surrounded by the coating layer 250. The implementation regions 222 formed on the substrate 210, and the plurality of components 220 formed therein, may be separated from each other.

In one embodiment, the plurality of components 220 may contact the first insulating layer 230 at a lower end adjacent to the substrate 210. The plurality of components 220 may be within a closed contour of (e.g., surrounded by) the second insulating layer 240 formed along an edge of the first insulating layer 230. The plurality of components 220 may be within the closed contour of the second insulating layer 240 and may be surrounded by the coating layer 250 formed on the first insulating layer 230.

According to one embodiment, the plurality of components 220 may include any one of a battery protection element, a charge and discharge switching element, an electrode identification element, or a plurality of passive elements. The plurality of components 220 may include connection terminals connected to the first electrode tab 111a and the second electrode tab 112a and an external terminal connected to an external load.

As illustrated in Fig. 6, according to one embodiment, the plurality of components 220 on the substrate 210 may have different heights. The plurality of components 220 on the substrate 210 may have different heights according to the specifications of the components 220. For example, in one or more embodiments, a height h1 of a charge and discharge switching element 220a may be higher than a height h2 of a connection terminal 220b connected to the second electrode tab 112a.

According to one embodiment, the first insulating layer 230 may be formed in regions other than the implementation regions 222 on the substrate 210. For instance, the first insulating layer 230 may be formed in all of the regions of the substrate 210 other than the implementation regions 222 on the substrate 210.

In one embodiment, the first insulating layer 230 may be configured to insulate the plurality of components 220 from the outside of the substrate 210. The first insulating layer 230 may be made of an insulating member or insulating material. The first insulating layer 230 may include, but is not limited to, photo solder resist (PSR) ink. For example, the first insulating layer 230 may be formed by printing and drying an insulating member including the PSR ink.

According to one embodiment, the second insulating layer 240 may be formed on the first insulating layer 230 and may be separated from (e.g., spaced apart from) the plurality of components 220. The second insulating layer 240 may be formed along the edge of the first insulating layer 230. The second insulating layer 240 may be formed as the closed contour along the edge of the first insulating layer 230.

According to one embodiment, the second insulating layer 240 may be at a position corresponding to an edge (e.g., the periphery) of the substrate 210. The second insulating layer 240 may be on the first insulating layer 230 at the position corresponding to the edge of the substrate 210.

According to one embodiment, the second insulating layer 240 may be on the first insulating layer 230 and extend along the edge of the substrate 210, and the coating layer 250 may be on an inner side (an interior) surrounded by the second insulating layer 240. In a procedure or process of coating the coating layer 250, the second insulating layer 240 can prevent (or at least mitigate) the coating layer 250 from flowing out of the substrate 210.

According to one embodiment, a thickness t2 of the second insulating layer 240 may be thicker than a thickness t1 of the first insulating layer 230. The second insulating layer 240 may be formed to be sufficiently thick to prevent (or at least mitigate) the coating layer 250 from flowing out of the substrate 210.

As illustrated in Fig. 6, according to one embodiment, a height h3 of the second insulating layer 240, for example, the height h3 of the second insulating layer 240 with respect to the substrate 210, may be higher than a height h4 of the coating layer 250. The second insulating layer 240 is higher than the coating layer 250, and thus, the coating layer 250 can be prevented (or at least mitigated) from flowing out of the substrate 210.

According to one embodiment, the height h3 of the second insulating layer 240 may be lower than the height h1 of the component 220a that is the highest (tallest) among the plurality of components 220, which is configured to prevent the overall thickness of the protection circuit module 200 from becoming thicker due to the second insulating layer 240.

According to one embodiment, the height h3 of the second insulating layer 240 may be lower than the height h2 of the component 220b that is the lowest (shortest) among the plurality of components 220, which is configured to prevent the second insulating layer 240 surrounding the edge of the substrate 210 from acting as a shield or barrier (e.g., an obstacle) in a process of connecting connection terminals on the first electrode tab 111a and the second electrode tab 112a and the protection circuit module 200.

According to one embodiment, the second insulating layer 240 may be made of an insulating member or an insulating material. The second insulating layer 240 may include, but is not limited to, photo solder resist (PSR) ink. For example, the second insulating layer 240 may be formed by printing and drying an insulating member including the PSR ink.

According to one embodiment, the coating layer 250 may be on the first insulating layer 230. The coating layer 250 may surround the plurality of components 220 on the first insulating layer 230. The coating layer 250 may be a single layer surrounding outer surfaces of the plurality of components 220.

In one embodiment, the coating layer 250 may be within the closed contour of (e.g., surrounded by) the second insulating layer 240. Within the closed contour of the second insulating layer 240, the plurality of components 220 may be in the implementation regions 222, and the coating layer 250 may be in regions other than the implementation regions 222.

According to one embodiment, the coating layer 250 may be lower (shorter) than the second insulating layer 240. The height h4 of the coating layer 250 relative to the substrate 210 may be lower than the height h3 of the second insulating layer 240 relative to the substrate 210. As described above, in order to prevent (or at least mitigate) the coating layer 250 from flowing out of the substrate 210, the coating layer 250 may be lower than the second insulating layer 240.

In one embodiment, the coating layer 250 may be lower than the plurality of components 220. The height h4 of the coating layer 250 relative to the substate 210 may be lower than the height h1 of the component 220 that is the highest (tallest) among the plurality of components 220, which is configured to prevent the overall thickness of the protection circuit module 200 from becoming thicker due to the coating layer 250.

According to one embodiment, the coating layer 250 may include an underfill coating material. A coating member on which the coating layer 250 is coated may be an underfill coating material. The underfill coating material may be an insulating resin. The coating layer 250 including the underfill coating material has high spreadability (e.g., relatively low viscosity), and thus, a thickness of the coating layer 250 coated on the first insulating layer 230 can be formed uniformly (or substantially uniformly).

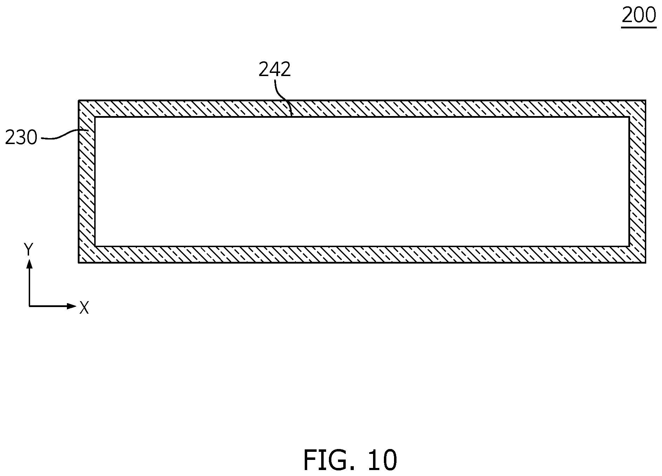

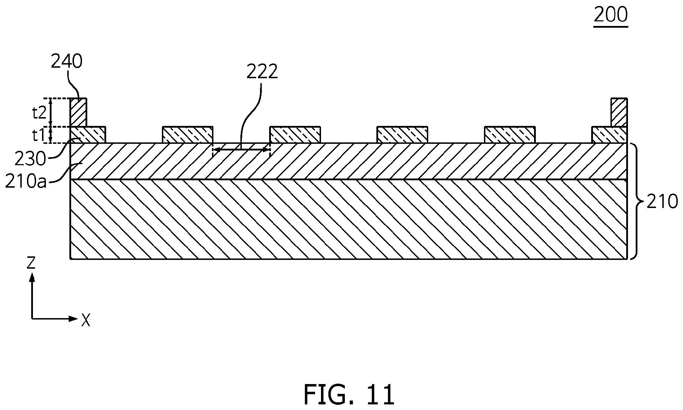

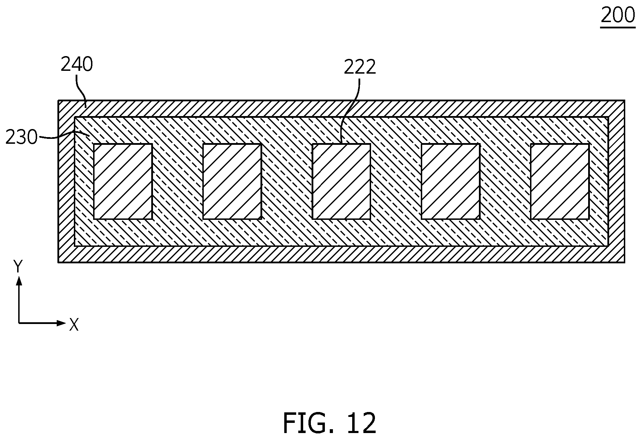

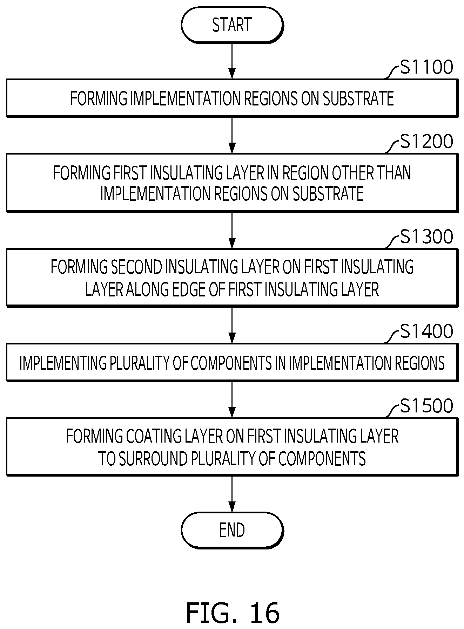

Figs. 7 to 15 are diagrams depicting a manufacturing process of the protection circuit module 200 according to one embodiment of the present disclosure. Fig. 16 is a flowchart illustrating tasks of the manufacturing process of the protection circuit module 200 according to one embodiment of the present disclosure.

Hereinafter, steps of a method of manufacturing the protection circuit module 200 according to one embodiment of the present disclosure will be described in detail with reference to Figs. 7 to 15.

According to one embodiment, in step S1100 of Fig. 16, the implementation regions 222 may be formed on the substrate 210. The substrate 210 may be electrically connected to the battery cell. The substrate 210 may support a configuration of the protection circuit module 200. The substrate 210 may be a printed circuit board (PCB) substrate 210. The substrate 210 may be made of one or more of FR-1, FR-4, CEM-1, CEM-3, TEFLON, ceramic, and/or metal. The substrate 210 may include a metal layer 210a configured to allow electrical signals to flow between the components.

According to one embodiment, a circuit that performs an operation capable of protecting the battery cell may be implemented on the substrate 210 to set the implementation regions 222. The plurality of components 220 may be formed (e.g., positioned) in the implementation regions 222, respectively. The plurality of components 220 may include any one of the battery protection element, the charge and discharge switching element, the electrode identification element, or the plurality of passive elements. The plurality of components 220 may include connection terminals connected to the first electrode tab 111a and the second electrode tab 112a and an external terminal connected to an external load.

According to one embodiment, in step S1200 of Fig. 16, the first insulating layer 230 may be formed in the regions other than the implementation regions 222 on the substrate 210 (e.g., the first insulating layer 230 may be formed in all of the regions other than the implementation regions 222 on the substrate 210).

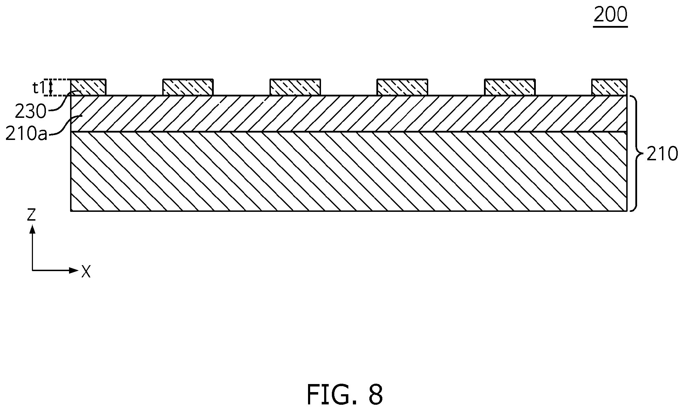

Referring to Figs. 7 and 8, according to one embodiment, a first insulating mask 232 may be positioned on the implementation regions 222 on the substrate 210. The first insulating mask 232 may expose only the regions other than the implementation regions 222 on the substrate 210. The first insulating layer 230 may be formed by applying a first insulating material to all the regions of the substrate 210 exposed (e.g., uncovered) by the first insulating mask 232. The first insulating mask 232 is configured to prevent (or at least mitigate) the first insulating material from being applied to the implementation regions 222. The first insulating layer 230 may be formed over all the regions other than the implementation regions 222 on the substrate 210. After the first insulating layer 230 is formed, the first insulating mask 232 may be removed.

According to one embodiment, the first insulating material forming the first insulating layer 230 may include, but is not limited to, photo solder resist (PSR) ink.

For example, the first insulating layer 230 may be formed by printing and drying the first insulating member including the PSR ink. The first insulating material including the PSR ink may be deposited on the substrate 210 at a thickness of about (approximately) 10 µm to about (approximately) 15 µm during a first printing operation. After the first printing and a drying procedure, the first insulating member may be deposited on the substrate 210 at a thickness of about (approximately) 20 µm to about (approximately) 30 µm during a second printing operation. Through this procedure, the first insulating layer 230 may be formed. A method of forming the first insulating layer 230 described above is only an example, and the present disclosure is not limited thereto.

According to one embodiment, in step S1300 of Fig. 16, the second insulating layer 240 may be formed on the first insulating layer 230 along the edge of the first insulating layer 230.

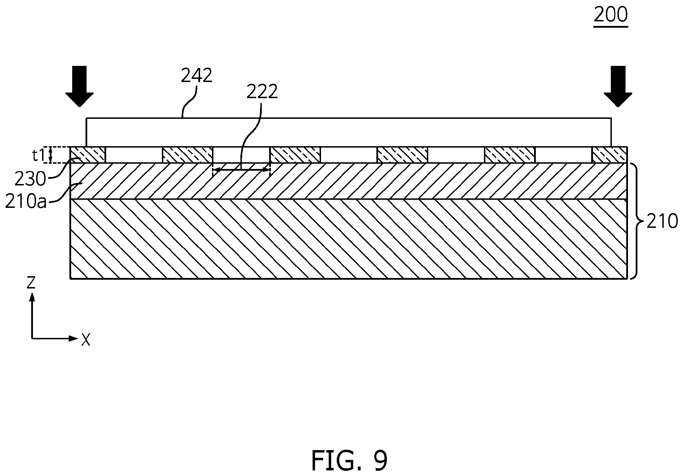

Referring to Figs. 9 to 12, according to one embodiment, a second insulating mask 242 may be positioned on the first insulating layer 230. The second insulating mask 242 may expose only a region on the first insulating layer 230 corresponding to the edge of the substrate 210. A second insulating material may then be applied, and thus the second insulating layer 240 may be formed at a position corresponding to the edge of the substrate 210 (e.g., the second insulating material may be deposited in the region of the first insulating layer 230 that is uncovered or exposed by the second insulating mask 242). The second insulating layer 240 may be formed at the position corresponding to the edge of the substrate 210 and may have a closed contour shape. After the second insulating layer 240 is formed, the second insulating mask 242 may be removed. The second insulating layer 240 may be formed in a closed contour along the edge of the first insulating layer 230.

According to one embodiment, a thickness t2 at which the second insulating layer 240 is formed in step S1300 may be thicker than a thickness t1 at which the first insulating layer 230 is formed in step S1200. The second insulating layer 240 is formed to be sufficiently thick to prevent (or at least mitigate) the coating layer 250 from flowing out of the substrate 210.

According to one embodiment, the second insulating material forming the second insulating layer 240 may include, but is not limited to, photo solder resist (PSR) ink.

For example, in one or more embodiments, the second insulating layer 240 may be formed by printing and drying the second insulating material including the PSR ink. The second insulating material including the PSR ink may be deposited on the first insulating layer 230 at a thickness of about (approximately) 10 µm to about (approximately) 15 µm during a first printing operation. After the drying procedure, printing may be performed repeatedly. The printing procedure may be repeated to form the second insulating layer 240 such that the second insulating member 240 has a thickness of about (approximately) 50 µm or more. A method of forming the second insulating layer 240 described above is only an example, and the present disclosure is not limited thereto.

According to one embodiment, in step S1400 of Fig. 16, the plurality of components 220 may be formed or positioned in the implementation regions 222.

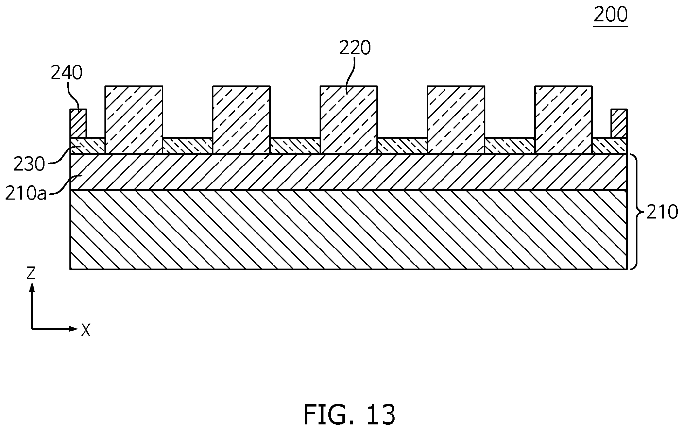

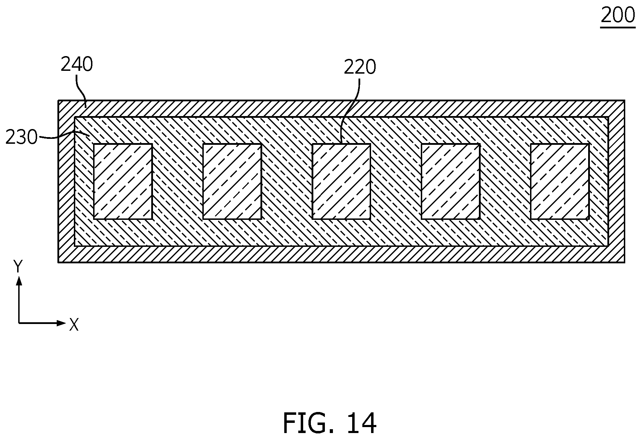

Referring to Figs. 13 and 14, according to one embodiment, the plurality of components 220 may be formed or positioned in the implementation regions 222 on the substrate 210. Each of the plurality of components 220 may be configured to transmit or receive an electrical signal through the metal layer 210a. The plurality of components 220 may be formed or positioned in the implementation regions 222 on the substrate 210 where the first insulating layer 230 is not formed. The implementation regions 222 on the substrate 210, and the plurality of components 220 located therein, may be separated from each other.

In one embodiment, the plurality of components 220 may contact the first insulating layer 230 at a lower end adjacent to the substrate 210. The plurality of components 220 may be positioned within a closed contour of (e.g., surrounded by) the second insulating layer 240 formed along an edge of the first insulating layer 230. The plurality of components 220 may be located within the closed contour of the second insulating layer 240.

According to one embodiment, the plurality of components 220 may have different heights on the substrate 210. The plurality of components 220 may be on the substrate 210 at different heights depending on the specifications of the components 220.

In step S1500 of Fig. 16, according to one embodiment, the coating layer 250 may be formed on the first insulating layer 230 to surround the plurality of components 220.

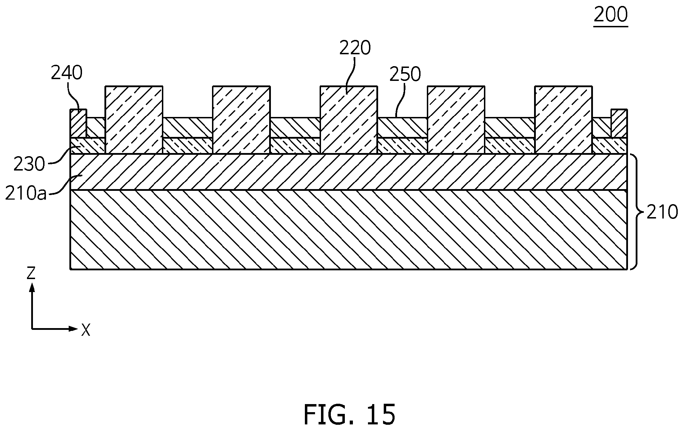

Referring to Fig. 15, according to one embodiment, the coating layer 250 may be formed on the first insulating layer 230. The coating layer 250 may be formed to surround the plurality of components 220 on the first insulating layer 230. The coating layer 250 may be formed as a single layer to surround outer surfaces of the plurality of components 220.

In one embodiment, the coating layer 250 may be formed within the closed contour of (e.g., surrounded by) the second insulating layer 240. Within the closed contour of the second insulating layer 240, the plurality of components 220 may be positioned in the implementation regions 222, and the coating layer 250 may be positioned in regions other than the implementation regions 222.

According to one embodiment, the coating layer 250 may be lower (shorter) than the second insulating layer 240. The height h4 at which the coating layer 250 is formed may be lower (shorter) than the height h3 at which the second insulating layer 240 is formed. As described above, in order to prevent (or at least mitigate) the coating layer 250 from flowing out of the substrate 210, the coating layer 250 may be formed to be lower than the second insulating layer 240.

According to one embodiment, the coating layer 250 may include an underfill coating material. A coating member on which the coating layer 250 is coated may be an underfill coating material. The underfill coating material may be an insulating resin. The coating layer 250 including the underfill coating material has high spreadability (e.g., low viscosity), and thus a thickness of the coating layer 250 coated on the first insulating layer 230 can be formed uniformly (or substantially uniformly).

The coating layer 250 formed in this manner may surrounded by the second insulating layer 240, may not flow (or at least may substantially not flow) to the outside of the substrate 210, and may surround the plurality of components 220. The coating layer 250 may be a single coating layer. As a result, the implementation strength of the components can be improved.

Although the present disclosure has been described above with respect to embodiments thereof, the present disclosure is not limited thereto. Various modifications and variations can be made thereto by those skilled in the art within scope of the appended claims.

**Description of Reference Symbols**

| | | | |
|---|---|---|---|
| 1: | secondary battery | 110: | electrode assembly |
| 111a: | first electrode tab | 112a: | second electrode tab |
| 115: | film portion | 120: | case |
| 200: | protection circuit module | 210: | substrate |
| 220: | plurality of components | 230: | first insulating layer |
| 240: | second insulating layer | 250: | coating layer |

## Claims

1. A protection circuit module (200) comprising:
a substrate (210) electrically connected to a battery cell;
a plurality of components (220) on implementation regions (222) of the substrate (210);
a first insulating layer in regions of the substrate (210) other than the implementation regions (222) on the substrate (210);
a second insulating layer (240) on the first insulating layer (230), the second insulating layer (240) being separated from the plurality of components (220); and
a coating layer (250) on the first insulating layer (230) and surrounding the plurality of components (220).

2. The protection circuit module (200) according to claim 1, wherein the second insulating layer (240) extends along an edge of the first insulating layer (230).

3. The protection circuit module (200) according to claim 2,
wherein the first insulating layer (230) is at all of the regions other than the implementation regions (222) on the substrate (210), and
wherein the second insulating layer (240) is at a position corresponding to the edge of the substrate (210).

4. The protection circuit module (200) according to claim 3,
wherein the second insulating layer (240) has a closed contour, and
wherein the plurality of components (220) are within the closed contour.

5. The protection circuit module (200) according to claim 4, wherein the coating layer (250) within the closed contour of the second insulating layer (240) and is in the regions other than the implementation regions (222) of the substrate (210).

6. The protection circuit module (200) according to any preceding claim, wherein the second insulating layer (240) is thicker than the first insulating layer (230).

7. The protection circuit module (200) according to any preceding claim, wherein a height of the second insulating layer (240) is lower than (i) than a highest height among a plurality of heights of the plurality of components; or (ii) a lowest height among a plurality of heights of the plurality of components (220).

8. The protection circuit module (200) according to any preceding claim, wherein the coating layer (250) is lower than (i) the second insulating layer (240); and/or (ii) each of the plurality of components (220).

9. The protection circuit module according to any preceding claim,
wherein the first insulating layer and the second insulating layer each comprise photo solder resist (PSR) ink;
and/or
wherein the coating layer comprises an underfill coating material.

10. A method of manufacturing a protection circuit module (200), the method comprising:
forming a first insulating layer (230) in regions of a substrate (210) other than implementation regions (222) on the substrate (210), the implementation regions (222) being regions where components (220) are to be located on the substrate (210);
forming a second insulating layer (240) on the first insulating layer (230), the second insulating layer (240) extending along an edge of the first insulating layer (230);
forming a plurality of the components (220) in the implementation regions; and
forming a coating layer (250) on the first insulating layer (230), the coating layer (250) surrounding the plurality of components (220).

11. The method of manufacturing the protection circuit module (200) in claim 10,
wherein the forming of the first insulating layer (230) comprises forming the first insulating layer (230) in all of the regions other than the implementation regions (222) on the substrate (210), and
wherein the forming of the second insulating layer (240) comprises forming the second insulating layer (240) at a position corresponding to an edge of the substrate (210).

12. The method of manufacturing the protection circuit module (200) in claim 11,
wherein the forming of the second insulating layer (240) comprises forming the second insulating layer (240) to have a closed contour, and
wherein the forming of the coating layer (250) comprises forming the coating layer (250) to be positioned within the closed contour and in the regions other than the implementation regions.

13. The method of manufacturing the protection circuit module (200) in any of claims 10 to 12, wherein the forming of the second insulating layer (240) comprises forming the second insulating layer (240) to be thicker than a thickness of the first insulating layer (230).

14. The method of manufacturing the protection circuit module (200) in any of claims10 to 13,
wherein the forming of the second insulating layer (240) comprises forming the second insulating layer (240) to be lower than a lowest height among a plurality of heights of the plurality of components (220); and/or
wherein the forming of the coating layer (250) comprises forming the coating layer (250) to be lower than the second insulating layer (240).

15. A secondary battery comprising an electrode assembly; a case accommodating the electrode assembly; and a protection circuit module according to any of claims 1 to 9 connected to the electrode assembly.
